(19)

Europäisches
Patentamt
European
Patent Office
Office européen
des brevets

(11) **EP 1 912 365 A1**

(12) **EUROPEAN PATENT APPLICATION**

(43) Date of publication:
**16.04.2008 Bulletin 2008/16**

(51) Int Cl.:
***H04L 1/00*** *(2006.01)*   ***H04L 1/02*** *(2006.01)*

(21) Application number: **06301033.4**

(22) Date of filing: **11.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Thomson Licensing**
**92100 Boulogne-Billancourt (FR)**

(72) Inventor: **Gueguen, Arnaud**
**35700, RENNES (FR)**

(74) Representative: **Ruellan-Lemonnier, Brigitte**
**Thomson**
**European Patent Operations**
**46 Quai Alphonse Le Gallo**
**92648 Boulogne Cedex (FR)**

(54) **Method for transmitting a stream of data in a communication system with at least two transmission antennas and transmitter implementing said method**

(57)     The present invention relates to a method for transmitting a stream of data in a communication system with at least two transmission antennas and a transmitter implementing said method.

The method comprises the steps of:
- dividing the stream of data elements in first words of k bits,
- encoding (1) the first words with a non binary code, the first words being the symbols of the non binary code and the size (k) in bits of the code symbols dividing the number of bits per space-time codeword,
- interleaving (2) the encoded symbols by a symbol wise interleaver
- splitting the interleaved bit stream thus obtained into groups of $\log_2(M)$ bits,
- mapping (3) the groups of $\log_2(M)$ bits onto complex symbols using a constellation of M points, then
- coding (4) the complex symbols using a space-time code to obtain space-time code words.

FIG.1

EP 1 912 365 A1

**Description**

The present invention relates to a method for transmitting a stream of data in a wireless communication system with at least two transmission antennas. The present invention also relates to a transmitter implementing this method and a decoder for receiving a signal transmitted using this method.

Existing and future wireless communication systems require constantly increasing throughputs while keeping a high quality of transmission. Among others, these systems have, as an objective, the establishing of services including high quality data and video transmission channels. Increasing the throughput, more specifically the spectral efficiency is crucial, whereas the dedicated radio spectrum and/or authorized transmit power of these wireless systems may not increase accordingly.

In this context, Multiple Input Multiple Output (MIMO) techniques, consisting in using several antennas, both at the transmitter and at the receiver sides, are very promising as they offer large channel capacity gains at a given overall transmit power. In particular, it has been shown that this theoretical channel capacity increases linearly with the minimum of transmit and receive antennas [E. Telatar," Capacity of Multi-antenna Gaussian Channels". Internal technical report, June 1995, Bell Laboratories http://mars.bell-labs.com/papers/]. Since this theoretical basis was published, many efforts have been made to design transmission and reception schemes that efficiently exploit the available capacity. In particular, so-called space-time coding schemes have been designed to do so. The space -time coding schemes encode the signal to be transmitted both over the time dimension and the space dimension (the transmit antennas). Alternately, the time dimension may be replaced by the frequency dimension for multi-carrier systems, yielding space -frequency coding. Among these schemes, a full rate code referred to as Golden code has recently been designed to address two transmit antennas, which outperforms any other codes.

To obtain large spectral efficiencies with two transmit antennas, state of the art approaches consist in combining an external powerful channel code such as a convolution code, a turbo code or a Low Density Parity Check code (LDPC) with a large modulation constellation and use space-time coding or spatial multiplexing over two transmit antennas. However, such schemes require high code rate to achieve the targeted high spectral efficiencies, which reduces their performance. Besides, they require producing soft bits at the output of the space-time detection to feed the input of the channel decoder, which leads to either too complex or suboptimal receivers.

The present invention makes use of this Golden code or any other type of robust space-time code, combined with adequate external non binary coding, interleaving and modulation to provide a highly spectrally efficient and robust transmission scheme that is easy to implement.

The present invention relates to a method for transmitting a stream of data in a communication system with at least two transmission antennas, said method comprising the steps of:

- dividing the stream of data in first words of k bits,
- encoding the first words with a non binary code, the first words being the symbols of the non binary code and the size (k) in bits of the code symbols dividing the number of bits per space-time codeword,-interleaving the encoded symbols by a symbol wise interleaver,
- splitting the interleaved symbols thus obtained into groups of $\log_2(M)$ elements,
- mapping the groups of $\log_2(M)$ elements onto complex symbols using a constellation of M points, then
- coding the complex symbols using a space-time code to obtain space-time code words.
  So, the present invention consists in using a well dimensioned non binary code, more particularly a Reed Solomon (RS) channel code over $GF(2^k)$, followed by a symbol interleaver, a digital modulation and a space-time code, more particularly a perfect code, and even more particularly a Golden code to achieve highly robust transmissions with at least two transmission antennas and at least two receiving antennas; This specific combination leads to significant advantages over the state of the art. In particular, it provides a better robustness characterized by e.g. a lower required SNR for a given residual error rate than state of the art solutions, at a given spectral efficiency. This results e.g. in a larger transmission range at a given throughput. Similarly, it provides a better spectral efficiency than state of the art solutions at a given robustness level. It also provides advantages in terms of implementation simplicity at a given performance level..
  The method of the present invention also comprises a step of interleaving space-time code words in space-frequency code words then modulating the space-frequency code words using a multi carrier modulation technique. The interleaving of space-time code words into space-frequency code words is such that the sub-carriers of a space-frequency code word are as far as possible.
  This brings several advantages:

- Replacing a space-time coding spread on several multi-carrier symbols with a space-frequency coding spread on several subcarriers of a same multi-carrier symbol reduces the decoding latency (and hence, e.g., buffering size) at the receiver side.

- Separating the subcarriers of a space-frequency codeword as much as possible allows exploiting the frequency diversity in addition to only the spatial diversity, hence increasing the scheme robustness.
- Introducing spatial diversity in a space-frequency codeword in average significantly reduces the complexity of a lattice based decoder at the receiver side, compared to the case of a decoding space-time codeword without time diversity.

With a 16 or 64 QAM modulation, the mapping used a Gray type code with a constellation wherein the labels of two adjacent points are modified on one bit.

With a 32 QAM modulation, the mapping used a quasi Gray code wherein the labels of two adjacent points are modified on a minimum number of one bit except for one point per quadrant.

The present invention also relates to a transmitter for implementing the above method comprising a first coding circuit using non binary code for coding the stream of data in symbols of k bits, a k bits symbol wise interleaving circuit, a mapping and modulation circuit for mapping symbols of $\log_2(M)$ bits in complex symbols among M possible values and a second coding circuit using a space-time code. The transmitter may also comprise a time frequency interleaving circuit followed by N multi carrier modulators, N corresponding to the number of transmission antennas.

Other advantages and characteristics of the present invention will become apparent from the detailed description of an implementation embodiment which is in no way limitative and the attached drawings in which:

FIG.1 is a block diagram illustrating a transmitter according to a preferred embodiment of the present invention,
FIG.2 is a schematic illustrating the operation of the symbol wise interleaving circuit,
FIG.3 is a representation of a 32 QAM constellation according to the invention,
FIG.4 is a schematic illustrating the operation of the time frequency interleaving circuit.

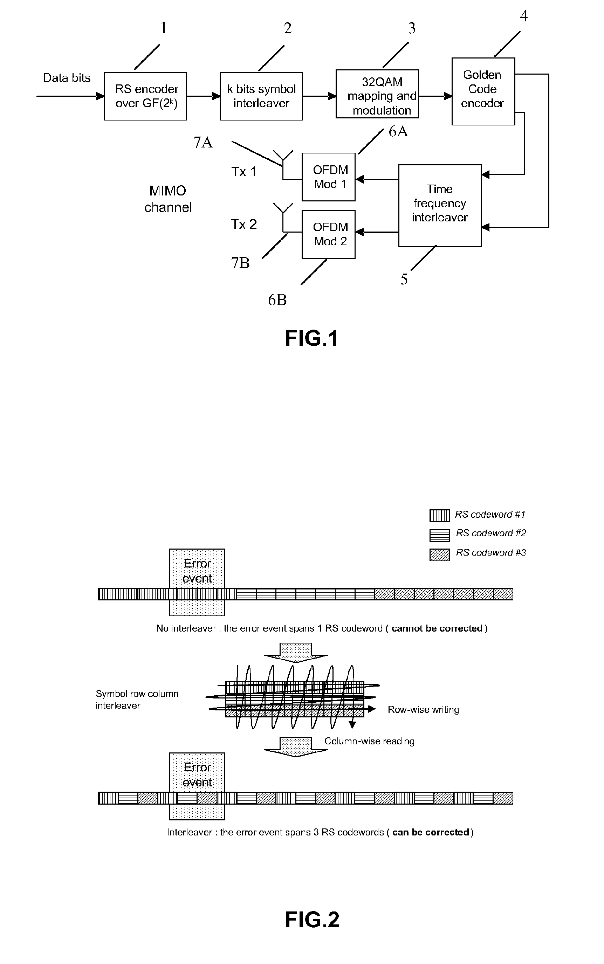

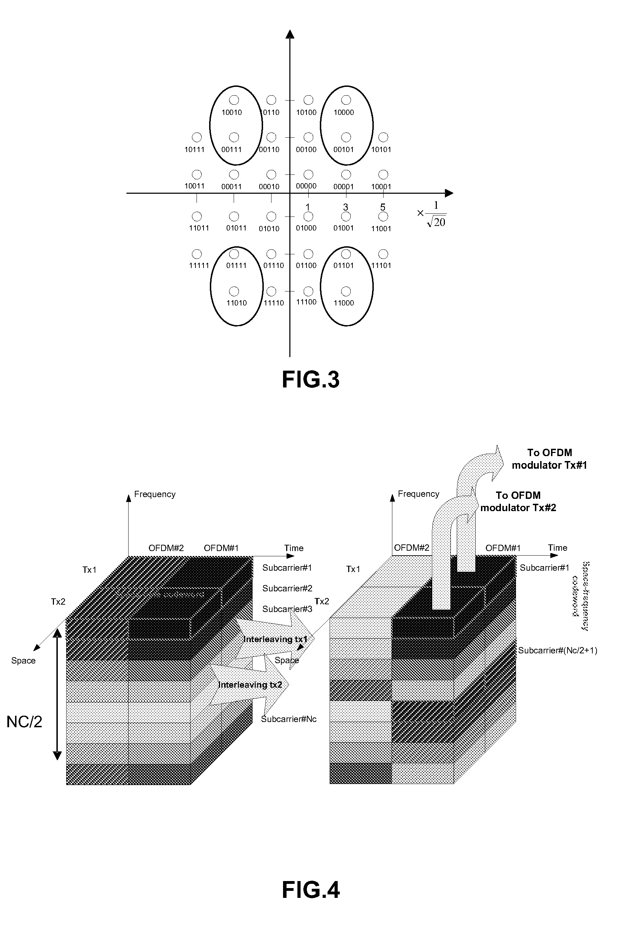

FIG.1 represents a base band transmitter according to one embodiment of the present invention. In this embodiment, the data bits are first encoded using a Reed Solomon encoder 1 as non binary code encoder. The encoder uses an alphabet of symbols made of k bits in which the symbol size k divides the number of bits per space-time code words used in the multi carrier modulation as explained here after. The non binary encoder produces from sequences of symbols, code words on the same k bits symbols alphabet. These symbols are then interleaved by a k bits symbols interleaving circuit 2. More specifically, the interleaving circuit is a row column interleaving circuit as explained here after with reference to FIG.2. The binary stream of interleaved symbols is split into groups of $\log_2(M)$ bits to be modulated by a QAM modulation. In this embodiment, the modulation is a 32 QAM modulation. Thus each group of $\log_2(M)$ comprises 5 bits. Each group of 5 consecutive bits is then mapped and modulated according to a 32 QAM modulation in the circuit 3. This type of modulation will be explained later on with reference to FIG.3 The resulting complex symbols are then grouped by four and encoded in the encoder 4 with a space-time code, more particularly a perfect code such as the Golden code. The resulting output four complex symbols are then transmitted over two well separated frequency bins of a same OFDM symbol in the present invention. The space-time code at the output of the Golden code encoder is turned into a space-frequency code using a time-frequency interleaving circuit 5. The two symbols streams resulting from the time-frequency interleaving circuit are sent to two OFDM modulators 6A and 6B associated with each transmitting antenna 7A and 7B. The resulting base band signals on the two paths are transposed to RF signals and sent to the antennas.

The method for transmitting a stream of data in a multiple antenna wireless transmission system according to one preferred embodiment of the present invention will be described with reference to Fig.2 to 4. The stream of data is divided in blocks of bits. Then, it is first encoded with a forward error correction (FEC) code. The FEC code is preferably a non binary code, more preferably in the present embodiment a Reed-Solomon (RS) code over $GF(2^k)$ where GF is the Gallois field and k is the symbol size in bits. In the present invention, the value of k is determined in function of the modulation and of a further coding. In this case, the modulation is a QAM modulation, more particularly a 32 QAM modulation and the coding is done using a space-time code, in particular a perfect code such as the Golden code. As a codeword of the Golden code encodes 20 bits in the case of a 32 QAM modulation having symbols of 5 bits (four 32QAM symbols) and codeword errors therefore span 20 bits, k is advantageously taken as dividing 20. Practical values for k are thus typically 5 and 10 here. Higher values of k induce a too high RS decoder complexity. In the case of 16QAM mapping, the Golden codewords would have spanned 16 bits and therefore an appropriate value for k would have been 8.

The encoded bits are then interleaved symbol-wise with a row column interleaver, where each symbol is made of k consecutive bits. The interleaver is designed according to the correction capability of the RS code. For instance, if k=5, each RS codeword spans at most $(2^{k-1})=31$ k-bits symbols and error events coming from the channel frequency and/or time selectivity may affect a large part of a given codeword, beyond its error correction capability. The aim of the symbol interleaver is to spread such errors on as many RS codewords as possible, ideally below the error correction capability of each of them. This is depicted on figure 2. More specifically, the top part of Figure 2 represents the RS code words at the input of the interleaver (or equivalently, without any interleaver). In this case, the code words are made each of 7 symbols ,each symbol being made of 5 bits. 3 consecutive RS codewords are represented on Figure 2. Without any interleaving, an error made on a space-time codeword would affect a single RS codeword and could not be corrected. So the data are sent on a symbol row-column interleaver. The code words are written row wise and read column wise. As shown at the bottom of Fig.2, the structure of the RS code words at the output is such that the RS code words are multiplexed with a symbol of a RS codeword 1 followed by a symbol of a RS codeword 2 followed by symbol of a RS codeword 3. As a result, the same error event on the space-time codeword now spans 3 RS code words and can be corrected.

The interleaved bit stream thus obtained is split into groups of $\log_2(M)$ bits, for example into groups of 5 bits in the case of a 32 QAM modulation. Each group of 5 consecutive bits is then mapped and modulated according to a 32QAM modulation as described in figure 3. The code used in this case can not be a Gray code wherein the labels of two adjacent points are modified on one bit. Such Gray code can be used with $2^{2n}$ QAM modulation where n is an integer, i.e. for instance 16QAM or 64QAM. As shown on figure 3, the groups of 5 bits are mapped onto complex symbols of a constellation wherein the constellation is a cross 32 QAM constellation and the label of two adjacent points are modified on a minimum number of one bit except for one set of two adjacent points (1 0010,00111; 10000,00101; 11000,01101; 11010,01111) in each quadrant. In the constellation $1/\sqrt{20}$ is a normalization factor that guarantees that the average symbol energy is 1.

In the present embodiment, the resulting complex symbols are then grouped by 4 and encoded with a Golden code. The Golden code is a particular type of space-time code that provides full transmit diversity while simultaneously allowing to obtain the same code rate as for spatial multiplexing. Indeed, a codeword of the Golden code carries 4 modulated symbols, it is transmitted over 2 antennas and spans 2 symbol durations. Combined with 32QAM, the overall spectral efficiency is then 10 bits/s/Hz or slightly less if we account for the RS code rate, which is usually close to 1.

The Golden code is defined by a complex 4x4 matrix and the encoding process by the multiplication of the input complex 4x1 symbol vector with the Golden code matrix.

More precisely, the encoding process consists in a multiplication of the complex input vector of Nsymb_per_STC (=4 here) symbols with the following complex matrix **C** that is isomorphic to a Golden code and presents the advantage of having many 1 s and Os :

$$\mathbf{C} = \alpha \begin{pmatrix} 1 & 0 & 0 & jr \\ 0 & 1 & -r & 0 \\ 0 & r & 1 & 0 \\ jr & 0 & 0 & 1 \end{pmatrix}, \text{ with } r = \frac{-1+\sqrt{5}}{2} = 0.6180 \tag{1}$$

$r$ is the opposite of the conjugate of the Golden number.

$\alpha = 0.8507$ is a normalization factor that guarantees that the energy is kept constant through the encoding process.

Denoting s1r, s2r, s3r, s4r the real parts of the input vector and s1i, s2i, s3i, s4i the imaginary parts, the output of the encoding process is given by:

$$\begin{pmatrix} c1r \\ c2r \\ c3r \\ c4r \end{pmatrix} + j \begin{pmatrix} c1i \\ c2i \\ c3i \\ c4i \end{pmatrix} = \mathbf{C} \left( \begin{pmatrix} s1r \\ s2r \\ s3r \\ s4r \end{pmatrix} + j \begin{pmatrix} s1i \\ s2i \\ s3i \\ s4i \end{pmatrix} \right) \tag{2}$$

$c1r$ and $c3r$ are the real parts of the encoded outputs sent on transmit antenna 1, respectively at time instants 1 and 2.
$c1i$ and $c3i$ are the imaginary parts of the encoded outputs sent on transmit antenna 1, respectively at time instants 1 and 2.
$c2r$ and $c4r$ are the real parts of the encoded outputs sent on transmit antenna 2, respectively at time instants 1 and 2.
$c2i$ and $c4i$ are the imaginary parts of the encoded outputs sent on transmit antenna 2, respectively at time instants 1 and 2.
From equation (2), the outputs are explicitly given by the following relationships:

$$c1r=\alpha(s1r-r{*}s4i)$$

$$c1i=\alpha(s1i+r{*}s4r)$$

$$c2r=\alpha(s2r-r{*}s3r)$$

$$c2i=\alpha(s2i-r{*}s3i)$$

$$c3r=\alpha(r{*}s2r+s3r)$$

$$c3i=\alpha(r{*}s2i+s3i)$$

$$c4r=\alpha(-r{*}s1i+s4r)$$

$$c4i=\alpha(r{*}s1r+s4i)$$

The choice for the Golden code in the present invention is motivated by its very good performance and availability in the public domain. However, in other embodiments of the invention, other types of space-time codes offering the same code rate and similar performance may be used. This is the case of any code referred to as a perfect code.

The resulting output 4 complex symbols are then transmitted on the 2 transmit antennas. Instead of being transmitted at 2 consecutive time instants as in the state of the art, they are transmitted over 2 well separated frequency bins of a same OFDM (orthogonal frequency division multiplexing) symbol in the present embodiment. In other words, the time dimension of the space-time code is replaced by the frequency dimension, hence the space-time code is turned into a space-frequency code. This is achieved by appropriate time-frequency interleaving preceding the OFDM modulation, as depicted on figure 4. It is obvious for the man skilled in the art that other multi carrier modulation can be used instead of the OFDM modulation. Figure 4 illustrates the time-frequency interleaving for space-time codewords 1 to Nc dedicated to 2 consecutive OFDM symbols denoted OFDM1 and OFDM2, where Nc is the number of used subcarriers by the multicarrier modulation on the dedicated bandwidth. The first Nc/2 space-time codewords are interleaved into space-frequency codewords on the first time instant OFDM1 while the remaining Nc/2 space-time codewords are interleaved into space-frequency codewords on the second time instant OFDM2. In the present embodiment the interleaving rule is slightly different for space-time codewords 1 to Nc/2 and space-time codewords Nc/2+1 to Nc. In a variant of the invention it may however be the same rule for all Nc space-time codewords. As shown on figure 4, the space-time code word 1 (Tx1 to T×2 on the 2 time intervals OFDM1 and OFDM2) is interleaved into a space-frequency code word transmitted on subcarriers 1 and Nc/2+1 (Tx1 to Tx2 on the time interval OFDM1). In other words, the time instant OFDM1 of the space-time codewords 1 to Nc/2 is transmitted at time instant OFDM1 on the subcarriers 1 to Nc/2, while the time instant OFDM2 of the same space-time codewords 1 to Nc/2 is transmitted at time instant OFDM1 on the subcarriers Nc/2+1 to Nc. Indeed, the interleaving is done so that the frequency bins carrying a space-frequency codeword are spaced as much as possible from each other. Moreover, the space-time code word Nc/2+1 (Tx1 to Tx2 on the 2 time intervals OFDM1 and OFDM2) is interleaved into a space-frequency code word transmitted on subcarriers Nc/2+1 and 1 (Tx1 to Tx2 on the time interval OFDM2). In other words, the time instant OFDM1 of the space-time codewords Nc/2+1 to Nc is transmitted at time instant OFDM2 on the subcarriers Nc/2+1 to Nc, while the time instant OFDM2 of the same space-time codewords Nc/2+1 to Nc is transmitted at time instant OFDM2 on the subcarriers 1 to Nc/2. The difference of interleaving rule for the first Nc/2 space-time codewords and the last Nc/2 space-time codewords presents an advantage in the implementation of the channel equalization step at the receiver side.

The 2 symbols streams addressing the 2 transmit antennas and resulting from the time-frequency interleaver are then sent to the OFDM modulators associated with each transmit antenna. The resulting baseband signals on the 2 paths are then transposed to RF and sent to the antennas

So, this interleaver turns the time dimension of the space time code into a frequency dimension, i.e. it turns the space-time code into a space-frequency code. The advantage is manifold:

- It allows exploiting both the spatial and the frequency diversity with the space-time code
- It reduces the probability that the lattice representing the space-time code at the receiver side is flat, and hence reduces the lattice decoding complexity implemented at the receiver side.
- By performing symmetrical interleaving operations on 2 consecutive OFDM symbols, it makes the equalization scheme more efficient at the receiver side. Indeed, it enables the equalization process manipulating better conditioned (full rank) matrices and thus avoids among others numerical stability issues, noise increase, etc.
- Except for the latency of 2 OFDM symbols that it introduces, it is costless in terms of complexity.

The invention outperforms 10bits/s/Hz state of the art schemes using 2 transmit antennas, when combined with a lattice based ML decoder at the receiver side.

The invention is versatile in terms of data rates and robustness.

The invention does not require soft decision outputs at the receiver side, in particular at the output of the space-time decoder, which has advantages in terms of implementation complexity and decoding latency.

The present invention has been described using specific error correction code, mapping code, modulation scheme, space- time code and multi-carrier modulation. However, other types of codes or modulations can be used without departing from the scope of the present invention as already mentioned above. For example, if a 64 QAM modulation ($\log_2(64)=6$ bits per symbol) is used, there are 24 bits per space-time code word. The value of k must divide 24 and give a non binary code satisfying a compromise between the correction capacity and the decoding complexity. Thus, the value of k can be chosen to be 8 giving a RS code over GF(256). Instead of a QAM modulation, a PSK modulation can also be used. The invention is described with two transmit antennas, however in a MIMO system, the number of transmit antennas might be different from 2 with an appropriate space-time code, this space-time code being a spatial multiplexing or a full diversity space-time block code or a perfect code when compatible with the number of transmit antennas.

In a variant, the invention can be used with single carrier modulation instead of multicarrier modulation. In such case, the time-frequency interleaver and OFDM modulators are replaced by single carrier modulators, each modulator being associated with a transmit antenna.

**Claims**

1. - Method for transmitting a stream of data in a communication system with at least two transmission antennas, said method comprising the steps of:

   - dividing the stream of data elements in first words of k bits,
   - encoding the first words with a non binary code, the first words being the symbols of the non binary code and the size (k) in bits of the code symbols dividing the number of bits per space-time codeword,
   - interleaving the encoded symbols by a symbol wise interleaver
   - splitting the interleaved bit stream thus obtained into groups of $\log_2(M)$ bits,
   - mapping the groups of $\log_2(M)$ bits onto complex symbols using a constellation of M points, then
   - coding the complex symbols using a space-time code to obtain space-time code words.

2. - Method according to claim 1, wherein the symbol wise interleaver is such that the errors on a space-time codeword are spread on as many non binary codewords as possible,

3. - Method according to claims 1 or 2, further comprising the step of interleaving space-time code words in space-frequency code words and modulating the space-frequency code words using a multi carrier modulation technique.

4. - Method according to claim 3, wherein the interleaving of space-time code words into space-frequency code words is such that the sub-carriers of a space-frequency code word are as far as possible.

5. - Method according to claim 4, wherein the interleaving of a set of consecutive space-time codewords, corresponding to a number dividing the number of subcarriers of a multicarrier modulation, is interleaved into a set of space-frequency codewords transmitted on a first multicarrier symbol.

6. - Method according to claim 5, wherein the interleaving of a first set of consecutive space-time codewords is different from the interleaving of a second set of space-time codewords, in the sense that a first time dimension of the space-time codewords of the first set are transmitted on different subcarriers from a first time dimension of the space-time codewords of the second set.

7. - Method according to any one of the claims 1 to 6, wherein the non binary code is a Reed Solomon (RS) code over $GF(2^k)$.

8. - Method according to any one of claims 1 to 7, wherein the mapping step is a QAM type mapping using a constellation wherein the labels of two adjacent points are modified on a minimum number of bits.

9. - Method according to claim 8, wherein the QAM modulation is a 16 or 64 QAM modulation.

10. - Method according to claims 8 or 9, wherein the mapping is done with a Gray type code.

11. - Method according to any one of claims 1 to 7, wherein the mapping step is a 32 QAM type mapping done with a quasi Gray type code wherein the labels of two adjacent points are modified on one bit except for one point per quadrant.

12. - Method according to any one of claims 1 to 7, wherein the space-time code is a perfect code such as the Golden Code or a spatial multiplexing or a full diversity space-time block code.

13. - A transmitter for implementing the method according to any one of claims 1 to 12 comprising a first coding circuit using a non binary code on symbols of k bits for coding the stream of data, a k bits symbol wise interleaving circuit, a mapping and modulation circuit for mapping groups of $\log_2(M)$ bits on complex symbols among M possible and a second coding circuit using a space-time code.

14. - The transmitter according to claim 13 further comprising a time frequency interleaving circuit followed by N multi carrier modulators, N corresponding to the number of transmission antennas.

15. - A decoder for receiving a signal transmitted using the method according to claims 1 to 12.

**FIG.1**

**FIG.2**

FIG.3

FIG.4

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/045000 A1 (MORLIER CELINE [FR] ET AL) 2 March 2006 (2006-03-02)<br>* paragraph [0031] *<br>* paragraph [0006] *<br>* paragraph [0007] *<br>* paragraph [0033] *<br>* paragraph [0036] - paragraph [0037] * | 1-15 | INV.<br>H04L1/00<br>H04L1/02 |
| Y | US 2005/185575 A1 (HANSEN CHRISTOPHER J [US] ET AL) 25 August 2005 (2005-08-25)<br>* paragraph [0073]; figure 10a *<br>* figure 21 *<br>* paragraph [0074] *<br>* paragraph [0078] *<br>* paragraph [0090] *<br>* paragraph [0098] *<br>* the whole document * | 1-15 | |
| A | BELFIORE J-C ET AL: "The Golden Code: A 2 x 2 Full-Rate Space-Time Code With Nonvanishing Determinants"<br>IEEE TRANSACTIONS ON INFORMATION THEORY, IEEE SERVICE CENTER, PISCATAWAY, NJ, US, vol. 51, no. 4, April 2005 (2005-04), pages 1432-1436, XP011129052<br>ISSN: 0018-9448<br>* the whole document * | 1-15 | **TECHNICAL FIELDS SEARCHED (IPC)**<br><br>H04L |
| A | EP 1 341 332 A (FUJITSU LTD [JP]) 3 September 2003 (2003-09-03)<br>* figures 1,3,4 * | 1-15 | |

-/--

The present search report has been drawn up for all claims

| Place of search | Date of completion of the search | Examiner |
|---|---|---|
| The Hague | 16 January 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 06 30 1033

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PAUL J. GENDRON AND T.C. YANG: "Environmental and Motion Effects on Orthogonal Frequency Division Multiplexed On-Off Keying" INTERNET ARTICLE, [Online] 5 March 2004 (2004-03-05), XP002414932 Retrieved from the Internet: URL:http://www.hlsresearch.com/High_Frequency_Conf/HF%20FINAL%20Papers%20(PDFs)/Final%20-%20Gendron.pdf> [retrieved on 2006-01-15] * the whole document * | 1-15 | |
| | ----- | | |
| | | | **TECHNICAL FIELDS SEARCHED (IPC)** |

The present search report has been drawn up for all claims

| Place of search | Date of completion of the search | Examiner |
|---|---|---|
| The Hague | 16 January 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                                                                  
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 30 1033

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2007

| Patent document cited in search report | | Publication date | Patent family member(s) | | Publication date |
|---|---|---|---|---|---|
| US 2006045000 | A1 | 02-03-2006 | CN | 1669264 A | 14-09-2005 |
| | | | JP | 2005533429 T | 04-11-2005 |
| US 2005185575 | A1 | 25-08-2005 | NONE | | |
| EP 1341332 | A | 03-09-2003 | WO | 0247304 A1 | 13-06-2002 |
| | | | JP | 3387919 B2 | 17-03-2003 |
| | | | US | 2003117647 A1 | 26-06-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Capacity of Multi-antenna Gaussian Channels. **E. TELATAR.** Internal technical report. Bell Laboratories, June 1995